# EUROPÄISCHE PATENTSCHRIFT

(11) **EP 0 770 861 B1**
(45) Veröffentlichungstag und Bekanntmachung des Hinweises auf die Patenterteilung: **12.12.2007**
(21) Anmeldenummer: 96113224.8
(22) Anmeldetag: 17.08.1996
(51) Int. Cl.: G01K 1/12

(54) **Sonde mit einseitig vorkragendem Kopfgehäuse**
Probe with laterally projecting probe head
Sonde à tête de transmission en porte-à-faux

(30) Priorität: 27.10.1995 DE 19540034
(43) Veröffentlichungstag der Anmeldung: 02.05.1997
(73) Patentinhaber: GESTRA AG, 28215 Bremen (DE)
(72) Erfinder: Borchers, Kerstin, 28307 Bremen (DE); Politt, Joachim-Christian, Dr., 28215 Bremen (DE); Hansemann, Heinrich, 28277 Bremen (DE); Schmitz, Günter, 26121 Oldenburg (DE); Laupichler, Herbert, 28844 Weyhe (DE); Schröter, Holger, 28832 Achim (DE); Müller, Jan-Hermann, 27798 Hude (DE)
(74) Vertreter: Eisenführ, Speiser & Partner

(56) Entgegenhaltungen:
- DE-A- 3 143 470
- DE-B- 1 016 465
- GB-A- 2 223 312
- US-A- 5 029 270
- US-A- 5 423 149

## Beschreibung

Die Erfindung betrifft eine Sonde der im Oberbegriff des Hauptanspruches spezifizierten Art.

Aus DE 31 43470 A1 ist eine Vorrichtung zur Steuerung von Ventilen zur Flüssigkeitszuleitung an rotierenden Flaschenfüllmaschinen bekannt. Diese Vorrichtung wird zur Steuerung der Abfüllung von Getränken eingesetzt, wobei die Abfüllung bei Raumtemperatur stattfindet. In Behältern, an denen Sonden gemäß des Oberbegriffs des Hauptanspruchs zum Einsatz kommen sollen, herrschen jedoch zum Teil sehr hohe Betriebstemperaturen, z.B. 300°C. Die maximal zulässige Einsatztemperatur der im Kopfgehäuse der Sonden befindlichen elektronischen Schaltungseinheit liegt aber wesentlich niedriger, z.B. 70 °C. Der Umfang der Schaltung und damit die Baugröße von Schaltungseinheit und Kopfgehäuse kann relativ groß sein. Um das Messsignal des Sensors für die Auswertung bzw. die Weiterleitung zu konditionieren, ist häufig eine umfangreiche Schaltung erforderlich. Sie ergibt sich aber beispielsweise auch dann, wenn ein Schaltverstärker oder ein ähnliches Auswertegerät in die Schaltungseinheit integriert wird. Maßnahmen zum Schutz des Kopfgehäuses vor hohen Betriebstemperaturen sind aus DE 31 43470 A1 nicht zu entnehmen.

Bei einer bekannten Sonde (DE-GM 82 16 323) trägt der Halsteil an seinem behälterfernen Ende ein topfförmiges Kopfgehäuse. Der rohrförmige Halsteil dient dazu, zwischen der elektronischen Schaltung und dem Behälter einen temperaturreduzierenden Abstand zu schaffen. Die radialen Kühlrippen am Halsteil der bekannten Sonde haben sich als nicht vorteilhaft erwiesen. Durch den für die Sonden verfügbaren Einbauraum bestehen Grenzen für die Länge des Halsteiles. Gezeigt hat sich, dass trotz der üblichen Wärmedämmung des Behälters innerhalb der bestehenden Längengrenzen bei hohen Betriebstemperaturen nicht die erforderliche niedrige Temperatur an der Schaltungseinheit erreicht wird, dies gilt insbesondere bei großen Kopfgehäusen.

Einige der Einsatzfälle erfordern zwei Sonden zugleich, beispielsweise eine Sonde zur kontinuierlichen Überwachung des Flüssigkeitsniveaus und eine zweite Sonde zur Sicherheitsüberwachung eines Mindestflüssigkeitsstandes im Behälter. Vielfach besteht dabei der Wunsch, beide Sonden an einem Flansch zu montieren und dann diesen an einem Anschlußflansch des Behälters anzubringen, so daß an dem Behälter für beide Sonden nur ein einziger Anschluß erforderlich ist. Um dies mit einem Flansch der dort üblichen Nennweite realisieren zu können, müssen beide Sonden mit sehr geringem Mittenabstand nebeneinander angeordnet werden. Die bekannten Sonden mit ausladendem Kopfgehäuse ermöglichen dies nicht.

Der Erfindung liegt die Aufgabe zugrunde, eine Sonde der eingangs genannten Art zu schaffen, deren Kopfgehäuse umfangreiche Schaltungen aufnehmen kann und die dennoch für den Einsatz bei hohen Betriebstemperaturen geeignet ist. Außerdem soll eine Anordnung von zwei Sonden mit geringem Mittenabstand möglich sein.

Diese Aufgabe wird durch die im Anspruch 1 angegebenen Merkmale gelöst.

Anders als ein allseits radial über den Halsteil hinauskragendes Kopfgehäuse behindert das gegenüber dem Halsteil mit einseitigem Versatz angeordnete Kopfgehäuse nicht die Konvektionsströmung der Luft, die den Halsteil umgibt. Die Luftkonvektion kann vielmehr weitgehend ungehindert erfolgen. Unter dem Kopfgehäuse bildet sich kein Luft- und damit auch kein Hitzestau aus, der das Kopfgehäuse und die darin befindliche Schaltungseinheit erwärmen würde. Auch mit großem Kopfgehäuse ist daher ein Einsatz bei hohen Betriebstemperaturen möglich. Sollen zwei Sonden nebeneinander angeordnet werden, kann dies geschehen, indem die beiden Kopfgehäuse sich jeweils zu der der benachbarten Sonde abgewandten Seite erstrecken. Ungeachtet der Größe des Kopfgehäuses können dadurch die Sonden mit dem geforderten geringen Mittenabstand ihrer Befestigungsgehäuse angeordnet werden.

Das Kopfgehäuse ist als Flachkörper aufgebildet und hochkant angeordnet. Es bietet dem Konvektionsstrom mit seiner behälterzugewandten Schmalseite sehr wenig Anströmfläche. Nur der in unmittelbarer Nähe des Halsteiles gelegene Teil der Schmalseite liegt im Konvektionsstrom. Infolge der zum Halsteil radialen Ausrichtung des Kopfgehäuses befindet sich - zumal bei großen, weit vorkragenden Kopfgehäusen - ein wesentlicher Teil der Schmalseite außerhalb der Luftströmung. Eine besonders große Temperaturdifferenz zwischen dem Behälter und der Schaltungseinheit resultiert daraus.

Die Schaltungseinheit befindet sich völlig neben dem Halsteil, was hinsichtlich der Temperatur sehr vorteilhaft ist. Zudem ermöglicht diese Gehäuseform eine besonders gute Nutzung des Innenraumes durch die Schaltungseinheit.

Die Unteransprüche haben vorteilhafte Weiterbildungen der Erfindung zum Gegenstand.

Nach Anspruch 2 ist der Innenraum des Kopfgehäuses von zwei Seiten zugänglich, es muss nur jeweils der entsprechende Deckel abgenommen werden. Dies ist beispielsweise von Vorteil, wenn das Kopfgehäuse im einen Einbaufall nur von seiner einen und im anderen nur von seiner anderen Seite zugänglich ist. Werden zwei Sonden mit geringem Mittenabstand nebeneinander angeordnet, dann sind die Innenräume beider Sonden von derselben Seite her zugänglich, trotz gegensätzlicher Ausrichtung der Kopfgehäuse. Ergänzend ist hierbei von Vorteil, wenn - wie der Anspruch 3 vorsieht - die Schaltungseinheit ohne Änderung oder zusätzliche Mittel wahlweise von der einen oder der anderen Seite im Kopfgehäuse befestigt werden kann.

Die Merkmale des Anspruches 4 ermöglichen ein besonders leichtbauendes und dennoch formstabiles Kopfgehäuse. Mit den Merkmalen des Anspruches 5 wird ohne zusätzliche bauliche Maßnahmen eine wirksame Abschirmung gegen eine Strahlung elektromagnetischer Wellen von außen in das Kopfgehäuse hinein sowie auch gegen eine Strahlung aus dem Kopfgehäuse heraus erzielt.

Der Anspruch 6 macht es durch die symmetrische Form der Deckel möglich, für beide Breitseiten des Kopfgehäuses baugleiche Deckel zu verwenden. Gleichgültig, ob das Kopfgehäuse vom Halsteil aus nach rechts oder nach links vorkragt, es kann ein und derselbe Deckel zum Verschließen der Breitseite verwendet werden. Von besonderem Vorteil ist dies, wenn das Kopfgehäuse an der Breitseite Anzeige- und/oder Bedienelemente aufweist

Nach Anspruch 7 wird die Erfindung vorteilhaft dadurch weitergebildet, dass das Kopfgehäuse an einer Breitseite auf der Symmetrieachse mindestens ein von außen sichtbares Anzeigeelement und/oder ein von außen zugängliches Bedienelement aufweist und an dem dortigen Deckel mindestens eine Durchgangsöffnung so auf der Symmetrieachse angeordnet ist, dass sich sowohl in der möglichen einen Einbauposition als auch in der möglichen anderen, gedrehten Einbauposition des Deckels, bei in beiden Fällen gleicher Position des Anzeige-/Bedienelementes, in dessen Bereich eine Durchgangsöffnung befindet.

Bevorzugt ist es, wenn gemäß Anspruch 8 das Kopfgehäuse an einer Breitseite mit Versatz zur Symmetrieachse mindestens ein von außen sichtbares Anzeigeelement und/oder ein von außen zugängliches Bedienelement aufweist, der dortige Deckel auf der Symmetrieachse mindestens eine Durchgangsöffnung aufweist, die sich so zu beiden Seiten der Symmetrieachse erstreckt, dass sich sowohl in der möglichen einen Einbauposition als auch in der möglichen anderen, gedrehten Einbauposition des Deckels, bei in beiden Fällen gleicher Position des Anzeige-/Bedienelementes, in dessen Bereich eine Durchgangsöffnung befindet, und am Deckel eine die Durchgangsöffnung verschließende Frontplatte mit dem Anzeige-/Bedienelement angeordnet ist.

Eine weitere vorteilhafte Ausbildung der Erfindung gemäß Anspruch 9 zeichnet sich dadurch aus, dass das Kopfgehäuse an einer Breitseite mit Versatz zur Symmetrieachse mindestens ein von außen sichtbares Anzeigeelement und/oder ein von außen zugängliches Bedienelement aufweist, der dortige Deckel beiderseits der Symmetrieachse mit Versatz zu ihr jeweils mindestens eine Durchgangsöffnung so aufweist, dass sich sowohl in der möglichen einen Einbauposition als auch in der möglichen anderen, gedrehten Einbauposition des Deckels, bei in beiden Fällen gleicher Position des Anzeige-/Bedienelementes, in dessen Bereich eine Durchgangsöffnung befindet, und am Deckel eine die Durchgangsöffnungen verschließende Frontplatte mit dem Anzeige-/Bedienelement angeordnet ist.

Die Ansprüche 10 und 11 haben vorteilhafte Befestigungen des Kopfgehäuses an dem Halsteil zum Gegenstand. Die der Befestigung dienenden Schraubmittel sind leicht zugänglich, da sie sich außerhalb des Bereiches der Schaltungseinheit befinden. Nach erfolgtem Anbau der Sonde an den Behälter kann das Kopfgehäuse nötigenfalls in einfacher Weise in die gewünschte Stellung geschwenkt und dort fixiert werden.

In der Zeichnung sind Ausführungsbeispiele der erfindungsgemäßen Sonde dargestellt. Es zeigt
- Fig. 1: eine Sonde in Ansicht mit teilweiser Schnittdarstellung,
- Fig. 2: das Kopfgehäuse der Sonde nach Fig. 1 in Draufsicht bei teilweiser Schnittdarstellung,
- Fig. 3: eine Einzelheit des Kopfgehäuses aus Fig. 2 in anderem Maßstab,
- Fig. 4: zwei nebeneinander angeordnete Sonden in anderem Maßstab,
- Fig. 5: ausschnittweise eine Sonde mit Anzeigeelement und nach rechts vorkragendem Kopfgehäuse,
- Fig. 6: die Sonde nach Fig. 5 mit nach links vorkragendem Kopfgehäuse,
- Fig. 7: einen Deckel der Sonde nach Fig. 5 im Querschnitt,
- Fig. 8: ausschnittweise eine erste Sonde mit Anzeige- und Bedienelementen und nach rechts vorkragendem Kopfgehäuse,
- Fig. 9: die Sonde nach Fig. 8 mit nach links vorkragendem Kopfgehäuse,
- Fig. 10: ausschnittweise eine zweite Sonde mit Anzeige- und Bedienelementen und nach rechts vorkragendem Kopfgehäuse und
- Fig. 11: die Sonde nach Fig. 10 mit nach links vorkragendem Kopfgehäuse,

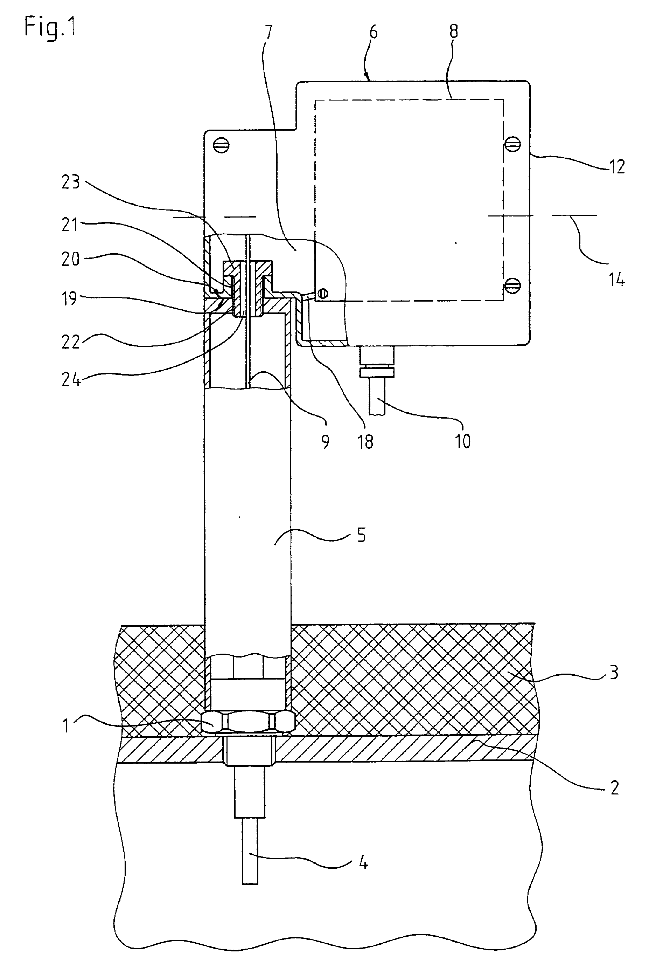

In Fig. 1 weist die Sonde ein Befestigungsgehäuse 1 auf, mit dem sie an einem Behälter 2 angebracht ist, der außenseitig eine Wärmedämmung 3 aufweist. An dem Befestigungsgehäuse 1 ist ein in den Behälter 2 hineinragender Sensor 4 vorgesehen, mit dem der Mediumfüllstand im Behälter 2 überwacht werden soll. Außerhalb des Behälters 2 trägt das Befestigungsgehäuse 1 einen sich vom Behälter 2 wegerstreckenden, aus der Wärmedämmung 3 herausragenden, rohrförmigen Halsteil 5, an dessen behälterfernem, freiem Ende ein Kopfgehäuse 6 angeordnet ist. In dessen Innenraum 7 befindet sich eine elektronische Schaltungseinheit 8. Ein elektrischer Leiter 9 erstreckt sich durch den Halsteil 5 und verbindet den Sensor 4 mit der Schaltungseinheit 8, die wiederum mit einer elektrischen Anschlußleitung 10 verbunden ist.

Das Kopfgehäuse 6 ist als hochkant angeordneter Flachkörper ausgebildet, dessen dem Befestigungsgehäuse 1 und dem Behälter 2 zugewandte Schmalseite sich in radialer Richtung zum Halsteil 5 erstreckt. Dabei weist das Kopfgehäuse 6 einen kleineren und einen größeren quaderförmigen Abschnitt auf. Der kleinere Abschnitt ist stirnseitig vor dem Halsteil 5 angeordnet. Der größere Abschnitt hingegen befindet sich auf einer Seite neben dem Halsteil 5; das Kopfgehäuse 6 kragt also auf einer Seite des Halsteiles 5 radial vor.

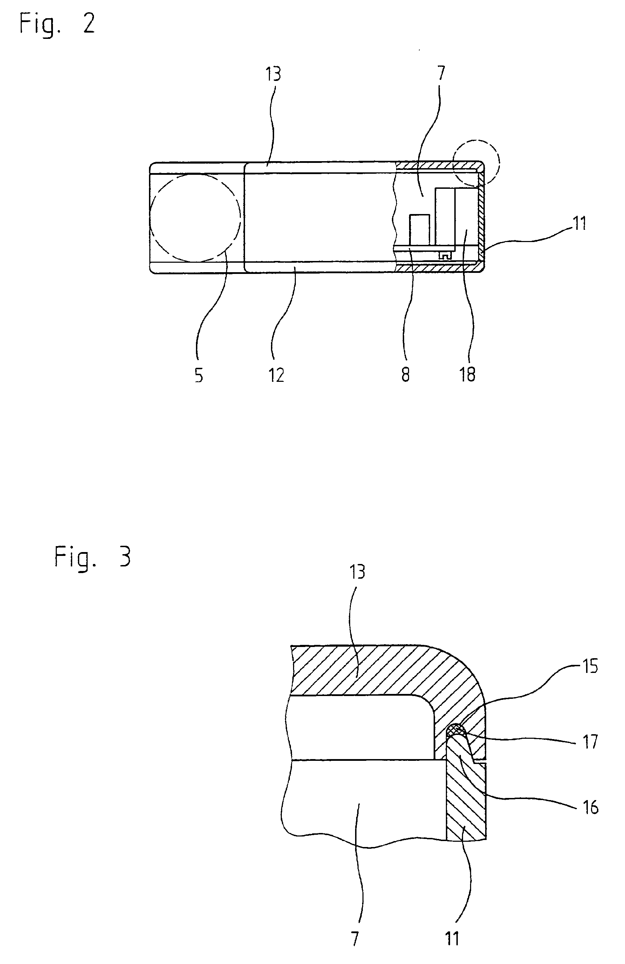

Die Schmalseiten des Kopfgehäuses 6 werden von einem umlaufenden, dünnwandigen Rahmen 11 gebildet. Zwei Deckel 12, 13 verschließen den Rahmen 11 beidseitig; sie bilden die Breitseiten des Kopfgehäuses 6. Die beiden Deckel 12, 13 sind baugleich. Sie und die angrenzenden Bereiche des Rahmens 11 weisen eine symmetrische Form und Außenkontur auf, bezogen auf eine quer zum Halsteil 5 verlaufende Symmetrieachse 14. Im übrigen sind beide Deckel 12, 13 an ihrem dem Rahmen 11 zugewandten Rand jeweils mit einer umlaufenden Aufnahmenut 15 versehen, in die der Rahmen 11 jeweils mit einer umlaufenden Leiste 16 hineingreift (Fig. 3), so daß das Kopfgehäuse 6 trotz geringer Wandstärke des Rahmens 11 sehr formstabil ist. Eine Dichtung 17 in der Aufnahmenut 15 eines jeden Deckels 12, 13 gewährleistet ein dichtes Verschließen des Kopfgehäuses 6. Beide Deckel 12, 13 und der Rahmen 11 bestehen aus Metall; sie sind elektrisch leitend und überdies auch elektrisch leitend miteinander verbunden. Somit ist eine Strahlung elektromagnetischer Wellen von außen in das Kopfgehäuse 6 hinein oder aus dem Kopfgehäuse 6 heraus unterbunden.

Die Schaltungseinheit 8 befindet sich im Innenraum 7 des Kopfgehäuses 6 ausschließlich in dessen größeren quaderförmigen Abschnitt. Am Rahmen 11 sind innenseitig Halterippen 18 für die Schaltungseinheit 8 vorgesehen. Sie sind so zwischen den beiden Deckeln 12, 13 angeordnet (Fig. 2), daß die Schaltungseinheit 8 wahlweise von der einen oder der anderen Breitseite des Kopfgehäuses 6 her in den Innenraum 7 eingesetzt und befestigt werden kann. Die Schaltungseinheit 8 kann also, je nach Notwendigkeit, nach Abnehmen des Deckels 12 oder des Deckels 13 eingebaut werden. Sollte die Schaltung der Schaltungseinheit 8 nicht auf einer Platine unterzubringen sein, können beispielsweise zwei unterschiedlich große Platinen vorgesehen werden (nicht dargestellt). Die größere Platine würde an den Halterippen 18 befestigt. Die kleinere Platine fände dahinter zwischen den Halterippen 18 Platz und wäre mittels Abstandsbolzen an der größeren Platine befestigt.

Das Kopfgehäuse 6 und der Halsteil 5 weisen korrespondierende Auflageflächen 19, 20 auf. Die Auflagefläche 19 befindet sich an der dem Befestigungsgehäuse 1 und dem Behälter 2 fernen Stirnseite des Halsteiles 5. Die Auflagefläche 20 ist im Bereich des kleineren quaderförmigen Abschnittes am Rahmen 11 vorgesehen, und zwar an dessen dem Befestigungsgehäuse 1 und somit dem Behälter 2 zugewandten Seite. Der Rahmen 11 weist in der Auflagefläche 20 ein zentrale Durchtrittsöffnung 21 und der Halsteil 5 in der Auflagefläche 19 eine zentrale Gewindebohrung 22 auf. Vom Innenraum 7 her durchsetzt eine Befestigungsschraube 23 die Durchtrittsöffnung 21. Sie ist in die Gewindebohrung 22 eingeschraubt und verbindet den Halsteil 5 und das Kopfgehäuse 6 lösbar miteinander. Zur Verbindung werden beide Auflageflächen 19, 20 aufeinandergepreßt; zwischen ihnen kann bei Bedarf eine Dichtung angeordnet werden (nicht dargestellt). Die Befestigungsschraube 23 weist einen zentralen Durchtritt 24 für den Leiter 9 auf. Anstelle der Befestigungsschraube 23 könnte am Halsteil 5 ein die Durchtrittsöffnung 21 durchsetzender Gewindezapfen oder -nippel vorgesehen sein, auf den im Innenraum 7 eine Befestigungsmutter geschraubt würde (nicht dargestellt).

Herrscht in dem Behälter 2 eine hohe Betriebstemperatur, unterbindet die Wärmedämmung 3 eine ungewollte Wärmeabgabe des Behälters 2 an die Umgebung. Infolge Wärmeleitung erwärmen sich allerdings das Befestigungsgehäuse 1 und der Halsteil 5, wobei mit zunehmendem Abstand vom Behälter 2 die Temperatur des Halsteiles 5 abnimmt. Im Bereich des erwärmten Halsteiles 5 bildet sich eine Konvektionsströmung der ihn umgebenden Luft aus. Auf einem großen Abschnitt des Halsteilumfanges kann die Strömung ungehindert erfolgen. Dort beaufschlagt die erwärmte Luft das Kopfgehäuse 6 nicht und erwärmt es folglich auch nicht. Lediglich auf der einen Seite des Halsteiles 5, auf der das Kopfgehäuse 6 vorkragt, trifft die Konvektionsströmung auf das Kopfgehäuse 6. Dieses ist ihr allerdings nur mit seiner Schmalseite zugewandt, und davon liegt auch nur der dem Halsteil 5 unmittelbar benachbarte Teil im Bereich der Konvektionsströmung. Ein großer Teil des Kopfgehäuses 6 befindet sich aufgrund seines radialen Abstandes zum Halsteil 5 außerhalb des Konvektionsstromes. Je weiter das Kopfgehäuse 6 einseitig vorkragt, um so weniger ist es der Wärmeeinwirkung ausgesetzt. Auch eine Sonde mit großbauender Schaltungseinheit 8 und dementsprechend weit einseitig vorkragendem Kopfgehäuse 6 kann somit an Behältern 2 mit großer Betriebstemperatur eingesetzt werden, ohne daß dabei an der Schaltungseinheit 8 eine unzulässig hohe Temperatur auftritt.

Alternativ zu der in Fig. 1 gezeigten senkrechten Anordnung des Halsteiles 5 kann die Sonde bei Bedarf auch mit schräg oder waagerecht verlaufendem Halsteil 5 eingebaut werden (nicht dargestellt). Auch dann wird das Kopfgehäuse 6 so ausgerichtet, daß es mit einer Schmalseite nach unten weist, es also auch dann hochkant angeordnet ist. Zur Ausrichtung des Kopfgehäuses 6 wird einer der Deckel 12, 13 abgenommen, die abseits der Schaltungseinheit 8 gelegene und damit gut zugängliche Befestigungsschraube 23 gelöst und das Kopfgehäuse 6 an dem Halsteil 5 in die erforderliche Stellung geschwenkt. Anschließend wird die Befestigungsschraube 23 wieder festgezogen und der Deckel angebracht.

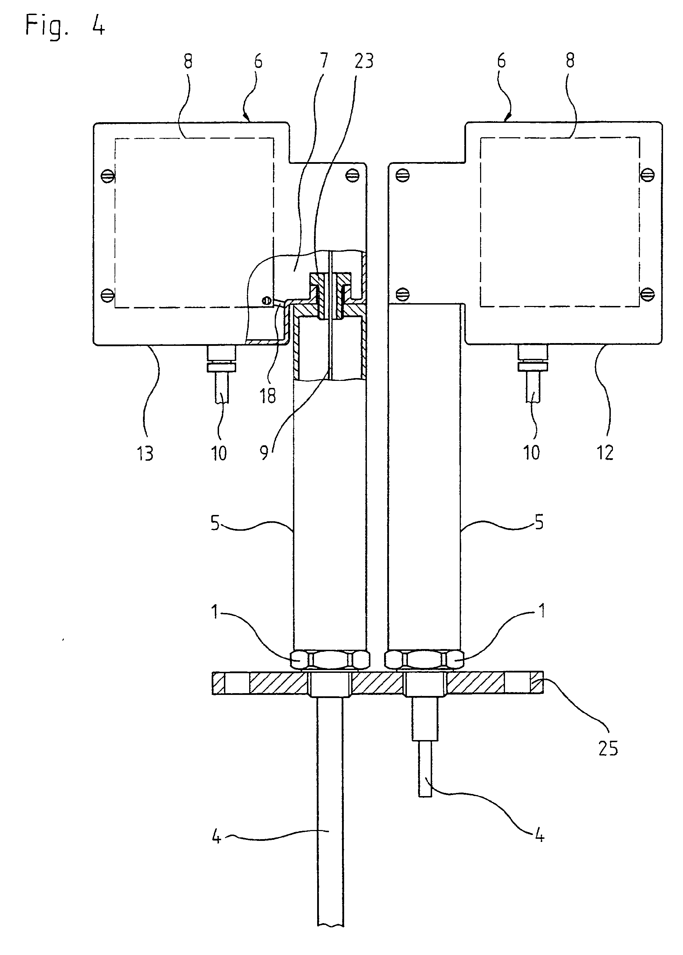

In Fig. 4 sind zwei Sonden nebeneinander an einem Flansch 25 angeordnet, der wiederum an einem entsprechenden Anschlußflansch eines Behälters (nicht dargestellt) angebracht wird. Die linke Sonde weist einen Sensor 4 zur kontinuierlichen Überwachung des Flüssigkeitsniveaus auf, während die rechte Sonde mit einem Sensor 4 zur Sicherheitsüberwachung eines Flüssigkeitshöchststandes versehen ist. Beide Sonden weisen als Schraubnippel gestaltete Befestigungsgehäuse 1 von geringem Durchmesser auf.

Die erste, rechte Sonde kann in komplettem Zustand in den Flansch 25 eingeschraubt werden. Sollte danach das Kopfgehäuse 6 nicht nach rechts gerichtet sein, läßt sich dies in einfacher Weise ändern. Nach Abnehmen des Deckels 12 wird die Befestigungsschraube 23 (s. Fig. 1) gelöst, das Kopfgehäuse 6 in die erforderliche Stellung geschwenkt und anschließend die Befestigungsschraube 23 wieder festgezogen. Nachdem die elektrische Verbindung zwischen der Schaltungseinheit 8 und der Anschlußleitung 10 hergestellt ist, wird dann auch wieder der Deckel 12 aufgesetzt.

An der zweiten, linken Sonde wird zumindest einer der Deckel 12, 13 abgenommen, die elektrische Verbindung zwischen Schaltungseinheit 8 und Leiter 9 gelöst, die Befestigungsschraube 23 herausgeschraubt und schließlich das Kopfgehäuse 6 von dem Halsteil 5 abgenommen. Nunmehr wird das Befestigungsgehäuse 1 der linken Sonde unmittelbar neben der rechten Sonde in den Flansch 25 eingeschraubt. Danach wird das Kopfgehäuse 6 wieder auf den Halsteil 5 aufgesetzt, nach links weisend ausgerichtet und mit der Befestigungsschraube 23 befestigt. Bei Bedarf kann die Schaltungseinheit 8 von den Halterippen 18 gelöst und von der einen Seite des Innenraumes auf dessen anderen Seite umgesetzt werden, wo sie wieder an den Halterippen 18 zu befestigen ist. In jedem Fall muß die elektrische Verbindung zwischen dem Leiter 9 und der Schaltungseinheit 8 wieder hergestellt werden. Der bzw. die Deckel 12, 13 werden wieder angebracht, nachdem auch die Anschlußleitung 10 angeschlossen wurde.

Da die Kopfgehäuse 6 beider Sonden jeweils einseitig am Halsteil 5 vorkragen und sich voneinander wegerstrecken, können beide Sonden trotz der großen Kopfgehäuse 6 mit geringem Mittenabstand der Befestigungsgehäuse 1 nebeneinander angeordnet werden.

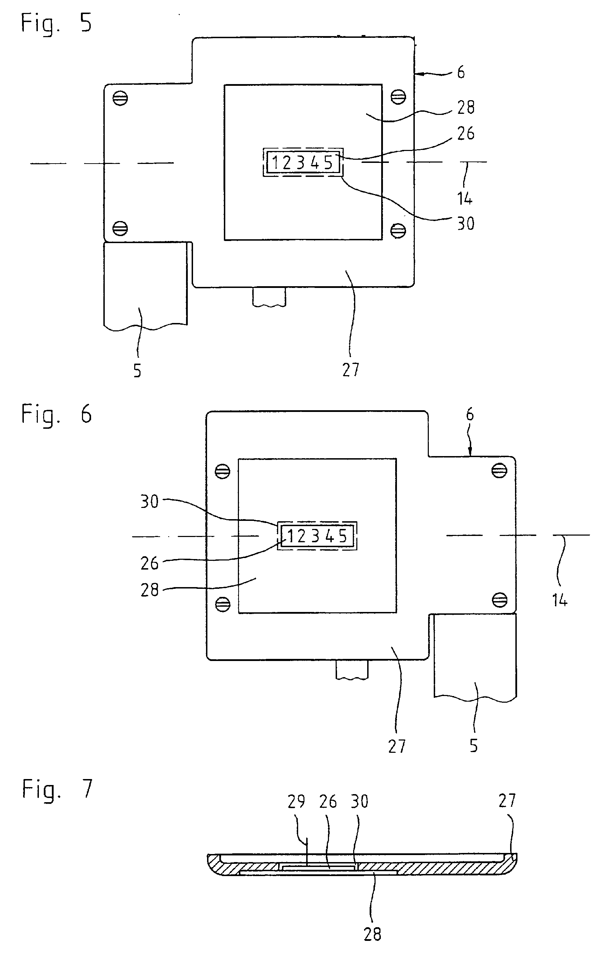

In den Fig. 5 und 6 ist die Sonde an einer Breitseite des Kopfgehäuses 6 auf der Symmetrieachse 14 mit einem elektrischen Anzeigeelement 26 versehen, das beispielweise dazu dienen kann, den vom Sensor 4 der Sonde ermittelten Istwert und/oder den vorgegebenen Sollwert anzuzeigen. Der Deckel 27 des Kopfgehäuses 6 trägt eine Frontplatte 28, an der das Anzeigeelement 28 angeordnet ist. Letzteres weist elektrische Anschlußleiter 29 (Fig. 7) zum Anschluß an die Schaltungseinheit 8 auf, und der Deckel 27 ist mit einer Durchgangsöffnung 30 versehen. Trotz unterschiedlicher Ausrichtung des Kopfgehäuse - nach rechts vorkragend bzw. nach links vorkragend - wird in den Fig. 5 und 6 derselbe Deckel 27 verwendet, er wird lediglich um 180 gedreht. Die Frontplatte 28 hat in beiden Fällen dieselbe Position, d. h. die Anzeige des Anzeigeelementes 26 steht nicht auf dem Kopf. Die Durchgangsöffnung 30 des Deckels 27 ist so auf der Symmetrieachse 14 positioniert und gestaltet, daß sie sich in beiden Einbaupositionen (Fig. 5 und 6) im Bereich des Anzeigeelementes 26 befindet, so daß der notwendige Freiraum für das Anzeigeelement 26 und für die Durchführung der Anschlußleiter 29 gegeben ist. Freibleibende Bereiche der Durchgangsöffnung 30 werden durch die Frontplatte 28 verschlossen.

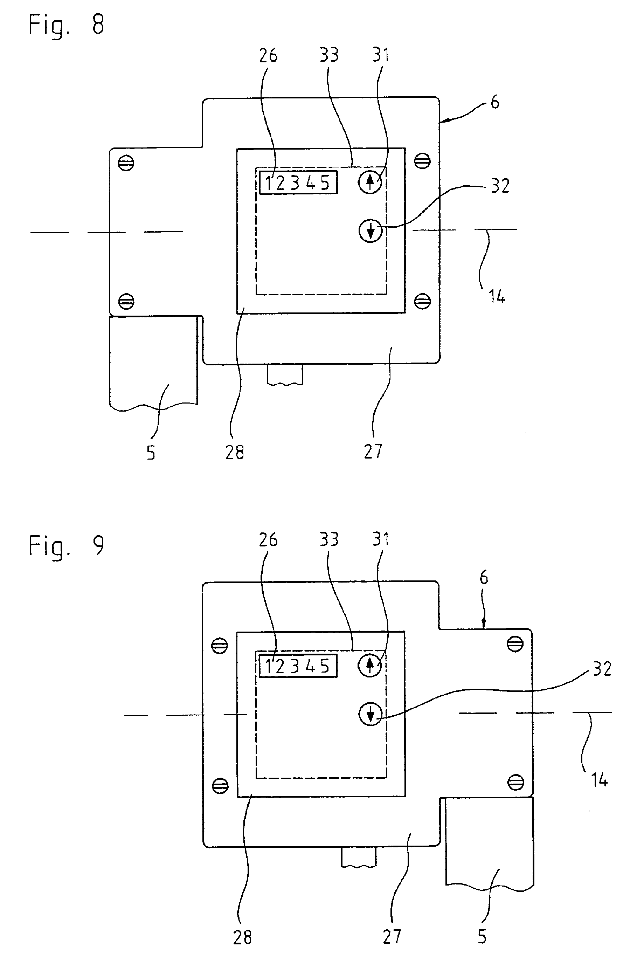

In den Fig. 8 und 9 ist das Anzeigeelement 26 gegenüber der Symmetrieachse 14 nach oben versetzt. Rechts daneben befindet sich ein erstes Bedienelement 31 und unter diesem, auf der Symmetrieachse 14 ein zweites Bedienelement 32. Als Bedienelemente 31, 32 sind beispielsweise Druckschalter vorgesehen, z. B. um den Sollwert für die Sonde variieren zu können. Der Deckel 27 weist eine einzige, große Durchgangsöffnung 33 auf, die sich so zu beiden Seiten der Symmetrieachse 14 erstreckt, daß in beiden Einbaupositionen des Deckels 27 (Fig. 8 und 9) ein Teilbereich der Durchgangsöffnung 33 im Bereich des Anzeigeelementes 26 und der Bedienelemente 31, 32 liegt. Die eine große Durchgangsöffnung 33 bietet eine besonders große Freiheit hinsichtlich der Positionierung der Anzeige- und Bedienelemente 26, 31, 32. Die entsprechend biegesteife Frontplatte 28 überdeckt die gesamte Durchgangsöffnung 33 und verschließt deren von dem Anzeigeelement 26 und den Bedienelementen 31, 32 nicht eingenommenen Bereich.

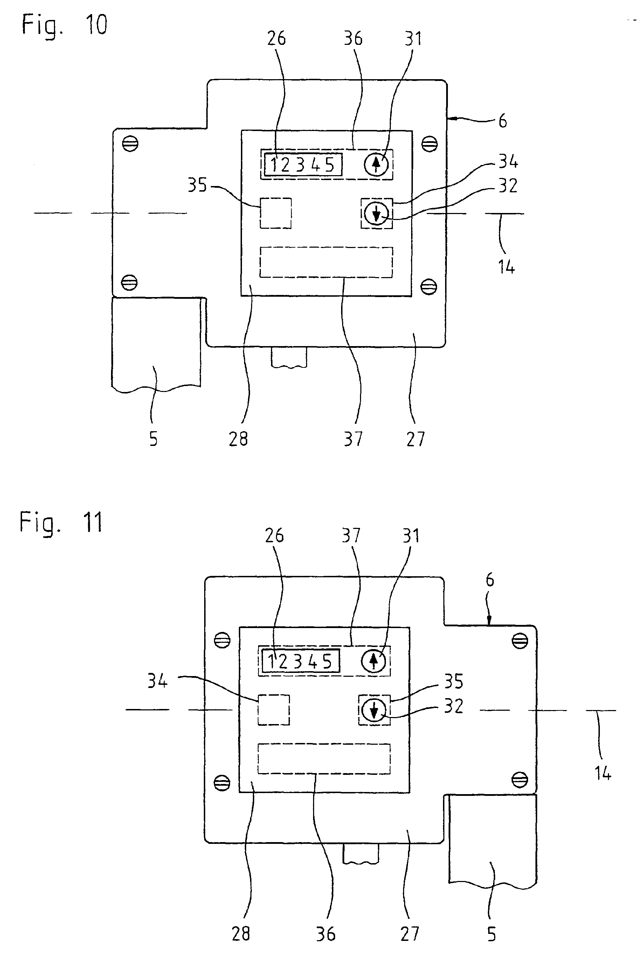

Von der zuvor beschriebenen Sonde unterscheidet sich die Sonde nach den Fig. 10 und 11 im wesentlichen dadurch, daß anstelle einer einzigen großen Durchgangsöffnung vier kleinere Durchgangsöffnungen 34, 35, 36, 37 im Deckel 27 vorgesehen ist. Die beiden Durchgangsöffnungen 34, 35 befinden sich mit Abstand voneinander auf der Symmetrieachse 14, während die anderen beiden Durchgangsöffnungen 36, 37 gegenüber der Symmetrieachse 14 nach oben bzw. nach unten versetzt sind. Die Positionierung und Gestaltung der Durchgangsöffnungen 34 - 37 ist so, daß sich in der einen Einbaulage des Deckels 27 (Fig. 10) die Durchgangsöffnung 36 im Bereich von Anzeigeelement 26 und Bedienelement 31 sowie die Durchgangsöffnung 34 im Bereich des Bedienelementes 32 befindet. In der anderen Einbaulage des Deckels 27 (Fig. 11) befindet sich statt dessen die Durchgangsöffnung 37 im Bereich von Anzeigeelement 26 und Bedienelement 31, während im Bereich des Bedienelementes 32 die Durchgangsöffnung 35 vorhanden ist. Freie Öffnungsbereiche und freie Durchgangsöffnungen werden von der Frontplatte 28 verschlossen. Angesichts der relativ kleinen Abmessungen der Durchgangsöffnungen 34 - 37 werden an die Biegesteifigkeit der Frontplatte 28 keine hohen Anforderungen gestellt. Statt biegesteiferer Platten können z. B. weniger biegesteife Folien Verwendung finden.

Die Größe der Durchtrittsöffnungen 30, 33 - 37 hängt unter anderem davon ab, ob die Anzeige- und Bedienelemente 26, 31, 32 selbst dort hinein- bzw. hindurchragen oder ob dies nur ihre Anschlußleiter 29 tun. Die Anzeige- und Bedienelemente 26, 31, 32 können an der Frontplatte 28 angeordnet sein oder alternativ an der Schaltungseinheit 8, von der sie zur Frontplatte 28 vorragen. Wenn die Anzeige- und Bedienelemente 26, 31, 32 sehr flachbauend und ohne überstand in die Frontplatte 28 integriert sind, dann erstrecken sich nur ihre Anschlußleiter 29 durch die Durchgangsöffnungen 30, 33 - 37.

Die Erfindung ist nicht auf Sonden mit Niveausensoren beschränkt, sondern auch für Sonden mit anderen Sensoren zur Überwachung von Medium in einem Behälter geeignet, wie z. B. Temperatursensoren, Drucksensoren, Leitfähigkeitsensoren. Die Sonden sind in einem großen Temperaturbereich einsetzbar, also nicht nur bei hohen Betriebstemperaturen.

### Bezugszeichenliste:

- 1: Befestigungsgehäuse
- 2: Behälter
- 3: Wärmedämmung
- 4: Sensor
- 5: Halsteil
- 6: Kopfgehäuse
- 7: Innenraum
- 8: Schaltungseinheit
- 9: Leiter
- 10: Anschlußleitung
- 11: Rahmen
- 12, 13: Deckel
- 14: Symmetrieachse
- 15: Aufnahmenut
- 16: Leiste
- 17: Dichtung
- 18: Halterippe
- 19, 20: Auflagefläche
- 21: Durchtrittsöffnung
- 22: Gewindebohrung
- 23: Befestigungsschraube
- 24: Durchtritt
- 25: Flansch
- 26: Anzeigelelement
- 27: Deckel
- 28: Frontplatte
- 29: Anschlußleiter
- 30: Durchgangsöffnung
- 31, 32: Bedienelemente
- 33 - 37: Durchgangsöffnungen

## Patentansprüche

1. Sonde zur Überwachung von Medium in einem Behälter (2) mit einem Befestigungsgehäuse (1) zur Anbringung der Sonde am Behälter (2), mindestens einem am Befestigungsgehäuse angeordneten Sensor (4), einem mit Abstand zum Befestigungsgehäuse (1) angeordneten Kopfgehäuse (6), in dem sich eine elektronische Schaltungseinheit (8) befindet, und einem das Kopfgehäuse (6) mit dem Befestigungsgehäuse verbindenden Halsteil (5), durch den sich mindestens ein elektrischer Leiter (9) erstreckt, wobei das Kopfgehäuse (6) in radialer Richtung des Hals-teiles (5) in seinen Abmessungen größer ist als der Halsteil (5) und das Kopfgehäuse (6) so am Halsteil (5) angeordnet ist, dass es auf einer Seite des Halsteils (5) radial vorkragt,
**dadurch gekennzeichnet, dass** das Kopfgehäuse (6) als Flachkörper ausgebildet ist, wobei eine Schmalseite des Kopfgehäuses (6) dem Befestigungsgehäuse (1) zugewandt ist und eine Schmalseite nach unten weist, und die gesamte Schaltungseinheit (8) sich in dem neben dem Halsteil (5) befindlichen, quaderförmig ausgebildeten Abschnitt des Kopfgehäuses (6) befindet.

2. Sonde nach Anspruch 1,
**dadurch gekennzeichnet, dass** das Kopfgehäuse (6) aus einem die Schmalseiten bildenden Rahmen (11) und zwei den Rahmen (11) beidseitig verschließenden Deckeln (12, 13, 27) als Breitseiten besteht.

3. Sonde nach Anspruch 2,
**dadurch gekennzeichnet, dass** am Rahmen (11) innenseitig Haltemittel (18) für die Schaltungseinheit (8) so angeordnet sind, dass daran eine wahlweise Befestigung der Schaltungseinheit (8) von jeder der beiden Breitseiten des Kopfgehäuses (6) her möglich ist.

4. Sonde nach einem der Ansprüche 2 und 3,
**dadurch gekennzeichnet, dass** der Rahmen (11) dünnwandig ausgebildet ist und die Deckel (12, 13) auf ihrer dem Rahmen (11) zugewandten Seite jeweils eine umlaufende Aufnahmenut (15) aufweisen, in die der Rand (16) des Rahmens (11) versteifend eingreift.

5. Sonde nach einem der Ansprüche 2 bis 4,
**dadurch gekennzeichnet, dass** der Rahmen (11) und die Deckel (12, 13) aus Metall bestehen und elektrisch leitend miteinander verbunden sind.

6. Sonde nach einem der vorhergehenden Ansprüche,
**dadurch gekennzeichnet, dass** die Deckel (12, 13, 27) - bezogen auf eine quer zum Halsteil (5) verlaufende Achse (14) - eine symmetrische Form haben.

7. Sonde nach Anspruch 6,
**dadurch gekennzeichnet, dass** das Kopfgehäuse (6) an einer Breitseite auf der Symmetrieachse (14) mindestens ein von außen sichtbares Anzeigeelement (26) und/oder ein von außen zugängliches Bedienelement (32) aufweist und an dem dortigen Deckel (12, 27) mindestens eine Durchgangsöffnung (30, 34, 35) so auf der Symmetrieachse (14) angeordnet ist, dass sich sowohl in der möglichen einen Einbauposition als auch in der möglichen anderen, gedrehten Einbauposition des Deckels (12, 27), bei in beiden Fällen gleicher Position des Anzeige-/Bedienelementes (26, 32), in dessen Bereich eine Durchgangsöffnung (30, 34, 35) befindet.

8. Sonde nach Anspruch 6,
**dadurch gekennzeichnet, dass** das Kopfgehäuse (6) an einer Breitseite mit Versatz zur Symmetrieachse (14) mindestens ein von außen sichtbares Anzeigeelement (26) und/oder ein von außen zugängliches Bedienelement (31) aufweist, der dortige Deckel (27) auf der Symmetrieachse (14) mindestens eine Durchgangsöffnung (33) aufweist, die sich so zu beiden Seiten der Symmetrieachse (14) erstreckt, dass sich sowohl in der möglichen einen Einbauposition als auch in der möglichen anderen, gedrehten Einbauposition des Deckels (27), bei in beiden Fällen gleicher Position des Anzeige-/Bedienelementes (26, 31), in dessen Bereich eine Durchgangsöffnung (33) befindet, und am Deckel eine die Durchgangsöffnung (33) verschließende Frontplatte (28) mit dem Anzeige-/Bedienelement (26, 31) angeordnet ist.

9. Sonde nach Anspruch 6,
**dadurch gekennzeichnet, dass** das Kopfgehäuse (6) an einer Breitseite mit Versatz zur Symmetrieachse (14) mindestens ein von außen sichtbares Anzeigeelement (26) und/oder ein von außen zugängliches Bedienelement (31) aufweist, - der dortige Deckel (27) beiderseits der Symmetrieachse (14) mit Versatz zu ihr jeweils mindestens eine Durchgangsöffnung (36, 37) so aufweist, dass sich sowohl in der möglichen einen Einbauposition als auch in der möglichen anderen, gedrehten Einbauposition des Deckels (27), bei in beiden Fällen gleicher Position des Anzeige-/Bedienelementes (26, 31), in dessen Bereich eine Durchgangsöffnung (36, 37) befindet, und am Deckel eine die Durchgangsöffnungen (36, 37) verschließende Frontplatte (28) mit dem Anzeige-/Bedienelement (26, 31) angeordnet ist.

10. Sonde nach einem oder mehreren der vorhergehenden Ansprüche,
**dadurch gekennzeichnet, dass** der Halsteil (5) an seiner dem Befestigungsgehäuse (1) fernen Stirnseite und das Kopfgehäuse (6) an seiner dem Befestigungsgehäuse (1) zugewandten Seite korrespondierende Auflageflächen (19, 20) aufweisen, das Kopfgehäuse (6) in seiner Auflagefläche (20) eine zentrale Durchtrittsöffnung (21) aufweist, am Halsteil (5) gehaltene, die Durchtrittsöffnung (21) durchsetzende Schraubmittel (23) vorhanden sind, die, nachdem sie festgezogen wurden, das Kopfgehäuse (6) und den Halsteil (5) an den Auflageflächen (19, 20) aufeinanderpressen, und im Bereich der Auflageflächen (19, 20) ein Durchtritt (24) für den elektrischen Leiter (9) vorhanden ist.

11. Sonde nach Anspruch 10, **dadurch gekennzeichnet, dass** die Schraubmittel (23) zentral den Durchtritt (24) für den elektrischen Leiter (9) aufweisen.

## Claims

1. Probe for monitoring a medium in a container (2), comprising a mounting housing (1) for mounting the probe on the container (2), at least one sensor (4) arranged on the mounting housing, a top housing (6) arranged at a distance from the mounting housing (1), in which top housing there is located a circuit unit (8), and a neck part (5) connecting the mounting housing to the top housing (6), at least one electrical conductor (9) extending through said neck part, the top housing (6) having greater dimensions in the radial direction of the neck part (5) than the neck part (5) and the top housing (6) being arranged on the neck part (5) in such a way that it protrudes radially on one side of the neck part (5), **characterised in that** the top housing (6) is configured as a flat body, a narrow side of the top housing (6) facing the mounting housing (1) and a narrow side pointing downward, and the entire circuit unit (8) being located in the cuboid-shaped portion of the top housing (6) located next to the neck part (5).

2. Probe according to claim 1, **characterised in that** the top housing (6) consists of a frame (11) forming the narrow sides and of two covers (12, 13, 27) which close the frame as wide sides on both sides.

3. Probe according to claim 2, **characterised in that** holding means (18) for the circuit unit (8) are arranged inside the frame (11) in such a way that the circuit unit (8) may be selectively mounted thereon from either of the two wide sides of the top housing (6).

4. Probe according to either claim 2 or claim 3, **characterised in that** the frame (11) is configured so as to have thin walls and the covers (12, 13) comprise a respective peripheral receiving groove (15) on their side facing the frame (11), in which groove the edge (16) of the frame (11) engages in a stiffening manner.

5. Probe according to any one of claims 2 to 4, **characterised in that** the frame (11) and the covers (12, 13) are made of metal and are connected to each other in an electrically conductive manner.

6. Probe according to any one of the preceding claims, **characterised in that** the covers (12, 13, 27) are symmetrical with respect to an axis (14) extending transversely to the neck part (5).

7. Probe according to claim 6, **characterised in that** the top housing (6) comprises at least one externally visible display element (26) on one wide side on the axis of symmetry (14) and/or an operating element (32) which is accessible from the outside, and at least one through opening (30, 34, 35) on the cover (12, 27) which is located there is arranged on the axis of symmetry (14) in such a way that, both in the one possible assembly position and in the other possible, rotated assembly position of the cover (12, 27), in both cases with the display/operating element (26, 32) in the same position, a through-opening (30, 34) is located in the region of said display/operating element.

8. Probe according to claim 6, **characterised in that** the top housing (6) comprises at least one externally visible display element (26) on one wide side offset from the axis of symmetry (14) and/or an operating element (31) which is accessible from the outside, the cover (27) which is located there comprises at least one through-opening (33) on the axis of symmetry (14), which through-opening extends to both sides of the axis of symmetry (14) in such a way that, both in the one possible assembly position and in the other possible, rotated assembly position of the cover (27), in both cases with the display/operating element (26, 31) in the same position, a through-opening (33) is located in the region of said display/operating element, and a front plate (28) closing the through-opening (33) is arranged on the cover with the display/operating element (26, 31).

9. Probe according to claim 6, **characterised in that** the top housing (6) comprises at least one externally visible display element (26) on one wide side offset from the axis of symmetry (14) and/or one operating element (31) which is accessible from the outside, the cover (27) which is located there comprises at least one respective through-opening (36, 37) on both sides of the axis of symmetry (14) offset from said axis such that, both in the one possible assembly position and in the other possible, rotated assembly position of the cover (27), in both cases with the display/operating element (26, 31) in the same position, a through-opening (36, 37) is located in the region of said display/operating element, and a front plate (28) closing the through-openings (36, 37) is arranged on the cover with the display/operating element (26, 31).

10. Probe according to any one or more of the preceding claims, **characterised in that** the neck part (5) comprises corresponding support surfaces (19, 20) on its end face remote from the mounting housing (1) and the top housing (6) comprises corresponding support surfaces (19, 20) on its side facing the mounting housing (1), the top housing (6) comprises a central through-opening (21) in its support surface (20), screw means (23) which extend through the through-opening (21) are provided on the neck part (5), which screw means, when tightened, secure the top housing (6) to the neck part (5) at the support surfaces (19, 20), and a passage (24) for the electrical conductor (9) is provided in the region of the support surfaces (19, 20).

11. Probe according to claim 10, **characterised in that** the screw means (23) centrally comprise the passage (24) for the electrical conductor (9).

## Revendications

1. Sonde pour surveiller un médium dans un réservoir (2) comportant un boîtier de fixation (1) pour appliquer la sonde dans le réservoir (2), au moins un capteur (4) disposé dans le boîtier de fixation, un boîtier de tête (6) disposé écarté du boîtier de fixation (1), dans lequel se trouve une unité de circuit électronique (8), et une partie de col (5), dans lequel s'étend au moins un conducteur électrique (9), reliant le boîtier de tête (6) au boîtier de fixation, dans laquelle le boîtier de tête (6) est plus grand dans la direction radiale de la partie de col (5) que la partie de col (5) et le boîtier de tête (6) est disposé dans la partie de col (5) de sorte qu'il fait saillie radialement sur un côté de la partie de col (5),
**caractérisée en ce que** le boîtier de tête (6) est réalisé sous la forme d'un corps plat, où un côté étroit du boîtier de tête (6) se trouve en vis-à-vis du boîtier de fixation (1) et un côté étroit est tourné vers le bas, et l'ensemble de l'unité de circuit (8) se trouve dans le tronçon du boîtier de tête (6) réalisé sous la forme d'un carré se trouvant près de la partie de col (5).

2. Sonde selon la revendication 1, **caractérisée en ce que** le boîtier de tête (6) est constitué d'un cadre (11) formant les petits côtés et de deux couvercles (12, 13, 27) sous la forme de côtés larges fermant le cadre (11) des deux côtés.

3. Sonde selon la revendication 2, **caractérisée en ce que** des moyens d'arrêt (18) pour l'unité de circuit (8), qui se trouvent à l'intérieur du cadre (11), sont disposés de sorte qu'une fixation au choix de l'unité de circuit (8) est possible par chacun des deux côtés larges du boîtier de tête (6).

4. Sonde selon l'une des revendications 2 et 3, **caractérisée en ce que** le cadre (11) est réalisé à parois minces et les couvercles (12, 13) présentent sur leurs côtés tournés vers le cadre (11) respectivement une rainure de réception périphérique (15), dans laquelle le bord (16) du cadre (11) pénètre de façon rigide.

5. Sonde selon l'une des revendications 2 à 4, **caractérisée en ce que** le cadre (11) et les couvercles (12, 13) sont réalisés en métal et sont reliés l'un à l'autre de façon électriquement conductrice.

6. Sonde selon l'une des revendications précédentes, **caractérisée en ce que** les couvercles (12, 13, 27) ont une forme symétrique - par rapport à un axe (14) s'étendant transversalement à la partie de col (5).

7. Sonde selon la revendication 6, **caractérisée en ce que** le boîtier de tête (6) présente dans un côté large sur l'axe de symétrie (14) au moins un élément d'affichage (26) visible depuis l'extérieur et/ou un élément de commande (32) accessible depuis l'extérieur et dans le couvercle (12, 27) au moins un orifice de passage (30, 34, 35) est disposé sur l'axe de symétrie (14) de sorte qu'un orifice de passage (30, 34, 35) se trouve dans la zone de l'élément d'affichage/de commande non seulement dans une position de montage possible mais également dans l'autre position de montage possible pivotée du couvercle (12, 27), dans la même position dans les deux cas de l'élément d'affichage/de commande (26, 32).

8. Sonde selon la revendication 6, **caractérisée en ce que** le boîtier de tête (6) présente dans un côté large avec un décalage par rapport à l'axe de symétrie (14) au moins un élément d'affichage (26) visible depuis l'extérieur et/ou un élément de commande (31) accessible depuis l'extérieur, le couvercle (27) à cet endroit présente sur l'axe de symétrie (14) au moins un orifice de passage (33), qui s'étend vers les deux côtés de l'axe de symétrie (14), de sorte qu'un orifice de passage (33) se trouve dans la zone de l'élément d'affichage/de commande (26, 31) non seulement dans une position de montage possible mais également dans l'autre position de montage possible pivotée du couvercle (27), dans la même position dans les deux cas de l'élément d'affichage/de commande (26, 31), et une plaque antérieure (28) fermant l'orifice de passage (33) est disposée avec l'élément d'affichage/de commande (26, 31) dans le couvercle.

9. Sonde selon la revendication 6, **caractérisée en ce que** le boîtier de tête (6) présente dans un côté large, avec un décalage par rapport à l'axe de symétrie (14), au moins un élément d'affichage (26) visible depuis l'extérieur et/ou un élément de commande (31) accessible depuis l'extérieur, le couvercle à cet endroit (27) présente des deux côtés de l'axe symétrique (14) avec un décalage par rapport à ce dernier, respectivement au moins un orifice de passage (36, 37), de sorte qu'un orifice de passage (36, 37) se trouve dans la zone de l'élément d'affichage/de commande non seulement dans une position de montage possible mais également dans l'autre position de montage possible pivotée du couvercle (27), dans la même position dans les deux cas de l'élément d'affichage/de commande (26, 31), et une plaque antérieure (28) fermant les orifices de passage (36, 37) est disposée dans le couvercle avec l'élément d'affichage/de commande (26, 31).

10. Sonde selon une ou plusieurs des revendications précédentes, **caractérisée en ce que** la partie de col (5) dans son côté antérieur éloigné du boîtier de fixation (1) et le boîtier de tête (6) dans son côté tourné vers le boîtier de fixation (1) présentent des surfaces portantes correspondantes (19, 20), le boîtier de tête (6) présente dans sa surface portante (20) un orifice de passage central (21), des éléments de vissage (23) traversant l'orifice de passage (21) et maintenus dans la partie de col (5) étant prévus, qui, après avoir été serrés, pressent l'un contre l'autre le boîtier de tête (6) et la partie de col (5) dans les surfaces portantes (19, 20), et un passage (24) pour le conducteur électrique (9) est prévu dans la zone des surfaces portantes (19, 20).

11. Sonde selon la revendication 10, **caractérisée en ce que** les éléments de vissage (23) présentent au centre l'orifice (24) pour le conducteur électrique (9).
